# EUROPEAN PATENT APPLICATION

(11) **EP 3 106 988 A2**
(43) Date of publication of application: **21.12.2016**
(21) Application number: 16173006.4
(22) Date of filing: 03.06.2016
(51) Int. Cl.: G06F 11/27

(54) **CONFIGURATION ERROR DETECTOR**

(30) Priority: 16.06.2015 US 201514740825
(71) Applicant: Honeywell International Inc., Morris Plains, NJ 07950 (US)
(72) Inventor: KREIDER, Thom, Morris Plains, NJ 07950 (US)
(74) Representative: Houghton, Mark Phillip

(57) **Abstract**

A processor having a built-in configuration error detector for a logic pipeline and a method for operating the same are provided. The processor may include, but is not limited to, a pipeline status indicator configured to determine when the logic pipeline is idle, a test vector source storing a test vector and configured to transmit the test vector to the logic pipeline when the pipeline status indictor determines that the logic pipeline is idle, and a validator configured to compare an output of the logic pipeline in response to the test vector to a predetermined data set, the validator configured to allow the processor to output data when the output of the logic pipeline in response to the test vector matches the predetermined data set and to block the processor from outputting data when the output of the logic pipeline does not match the predetermined data set.

## Description

### TECHNICAL FIELD

The present disclosure generally relates to processing, and more particularly relates to runtime processor integrity testing.

### BACKGROUND

Ionizing radiation, power supply voltage glitches, manufacturing defects, and numerous other effects can corrupt circuitry by changing the electrical state of a circuit element. Some systems guard against the effects of single event effects by implementing voting systems having redundant circuitry. For example, a system may utilize three separate processors and utilize a voting system to determine a valid output. In other words, if at least two of the three processors output the same value, the output is assumed to be valid. However, voting systems are expensive as at least three times the hardware is required to implement the system. Other systems may continuously check a configuration of a circuit by scrubbing the circuit for configuration errors. However these types of systems can still allow a corrupted circuit to output data until the configuration error is detected.

### BRIEF SUMMARY

In one embodiment, for example, a processor is provided. The processor may include, but is not limited to, a logic pipeline configured to process input data and a built-in configuration error detector for detecting a change to a configuration of the logic pipeline. The built-in configuration error detector may include, but is not limited to a pipeline status indicator configured to determine when the logic pipeline is idle, a test vector source coupled to the pipeline status indicator and selectively coupled to an input of the logic pipeline, the test vector source storing at least one test vector, the test vector source configured to transmit the at least one test vector to the logic pipeline when the pipeline status indictor determines that the logic pipeline is idle, and a validator coupled to an output of the logic pipeline, the validator configured to compare an output of the logic pipeline in response to the test vector to a predetermined data set, the validator configured to allow the processor to output data when the output of the logic pipeline in response to the test vector matches the predetermined data set and to block the processor from outputting data when the output of the logic pipeline in response to the test vector does not match the predetermined data set.

In another embodiment, a built-in configuration error detector for a logic pipeline in a processor is provided. The built-in configuration error detector may include, but is not limited to, a pipeline status indicator configured to determine when the logic pipeline is idle, a test vector source coupled to the pipeline status indicator and selectively coupled to an input of the logic pipeline, the test vector source storing at least one test vector, the test vector source configured to transmit the at least one test vector to the logic pipeline when the pipeline status indictor determines that the logic pipeline is idle, and a validator coupled to an output of the logic pipeline, the validator configured to compare an output of the logic pipeline in response to the test vector to a predetermined data set, the validator configured to allow the processor to output data when the output of the logic pipeline in response to the test vector matches the predetermined data set and to block the processor from outputting data when the output of the logic pipeline in response to the test vector does not match the predetermined data set.

In yet another embodiment, a method for validating a configuration of a logic pipeline of a processor is provided. The method may include, but is not limited to detecting, by a pipeline status identifier, when the logic pipeline is idle, inserting, by a test vector source, a test vector into the logic pipeline, comparing, by a validator, an output of the logic pipeline in response to the test vector to an expected data set, and opening, by the validator, a switch coupled between the logic pipeline and an output of the processor, when the output of the logic pipeline in response to the test vector does not match the expected data set.

### BRIEF DESCRIPTION OF THE DRAWINGS

The detailed description will hereinafter be described in conjunction with the following drawing figures, wherein like numerals denote like elements, and wherein:
FIG. 1 is a block diagram of a processor, in accordance with an embodiment;
FIG. 2 is another block diagram of an exemplary processor having a built-in configuration error detector, in accordance with an embodiment;
FIG. 3 is yet another block diagram of an exemplary processor having a built-in configuration error detector, in accordance with an embodiment;
FIG. 4 is yet another block diagram of an exemplary processor having a built-in configuration error detector, in accordance with an embodiment; and
FIG. 5 is a flow diagram illustrating an exemplary method for operating a processor having a built-in configuration error detector, in accordance with one embodiment.

### DETAILED DESCRIPTION

The following detailed description is merely exemplary in nature and is not intended to limit the invention or the application and uses of the invention. As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the invention and not to limit the scope of the invention which is defined by the claims. Furthermore, there is no intention to be bound by any expressed or implied theory presented in the preceding technical field, background, brief summary, or the following detailed description.

In accordance with one embodiment, processor having a built-in configuration error detector is provided. The built-in configuration error detector unobtrusively tests a configuration of a processor before and after normal operation of the processor. As discussed in further detail below, the built-in configuration error detector inserts test vectors during idles in operation of a logic pipeline to test the configuration of the logic pipeline. Furthermore, the built-in configuration error detector is a hardware based tester internal to the processor, and, thus, is invisible to any external software application and does not require any external or software based interrupts to operate.

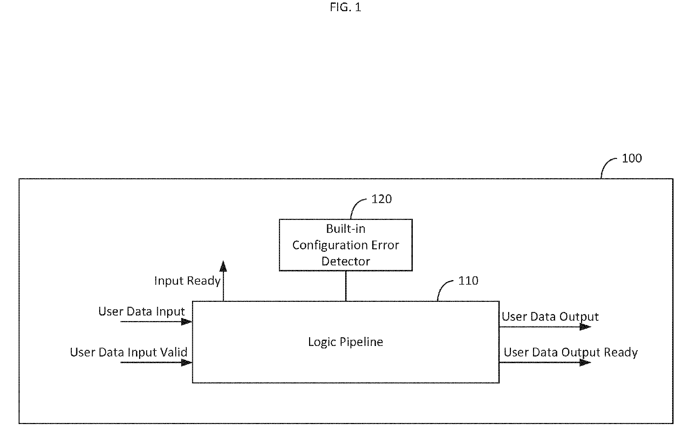

FIG. 1 is a block diagram of a processor 100, in accordance with an embodiment. In one embodiment, for example, the processor may be a static random-access memory (SRAM) type field programmable gate array (FPGA). SRAM is a type of semiconductor memory that uses bistable latching circuitry to store each bit. SRAM based FPGA's contain an array of SRAM memory units which store the FPGA application designers intended logic circuitry. In other embodiments, for example, the processor may be an application specific integrated circuit (ASIC) or any other logic device which utilizes a logic pipeline 110, as discussed in further detail below.

Unlike conventional central processing units (CPU's) with many short combinatorial logic paths, the logic pipeline 110 is a relatively long logic path through the processor 100. When the processor 100 is an ASIC or the like, the logic of the logic pipeline 110 is fixed upon manufacturing. When the processor 100 is programmable, such as an SRAM FPGA, or the like, the logic of the logic pipeline 110 is fixed upon configuration of the part. The logic pipeline 110 receives data from the processor 100 and/or a data source external to the processor 100 and performs a logical data operation on the received data. The logic pipeline 110 could have myriad of uses as the processor 100 can be arranged to implement any logic circuit. Some possible logic operations performed by the logic pipeline 110 include, but are not limited to, motor control in satellites, video processing in medical imaging systems, software defined radio transceivers, fast Fourier transform logic in filtering applications. However, a wide variety of logic implementations could be implemented in the logic pipeline 110.

The processor 100 further includes a built-in configuration error detector 120. The built-in configuration error detector 120 verifies that the configuration of the logic pipeline 110 of the processor 100 has not been changed due to ionizing radiation or other sources of interference. As discussed above, ionizing radiation, power supply voltage glitches, manufacturing defects, and numerous other effects can corrupt circuitry by changing the electrical state of one or more elements in the logic pipeline 110 of the processor 100. The errors can be catastrophic, causing the failure of the processor 100 or other components coupled to the processor 100. For example, if the processor 100 is being used to calculate current commands of a motor in a pump, an error introduced by ionizing radiation, voltage glitch, or manufacturing defect could cause the processor 100 to output a control signal (e.g., a motor winding current command) which could stress or even break the motor, the motor drive electronics, the pump, or the fluid moving through the pump. In pumping applications such as a pace-maker, a petroleum pipeline, or an aircraft engine this disruption can lead to loss of life or significant financial loss.

As discussed in further detail below, the built-in configuration error detector 120 is a hardware system internal to the processor 100. Accordingly, the built-in configuration error detector 120 allows the processor 100 to test itself for configuration errors. The construction of the built-in configuration error detector 120 may vary depending upon what type of processor 100 is being used. In embodiments where the processor 100 is a SRAM FPGA, for example, the components of the built-in configuration error detector 120 may be constructed from FPGA logic within the processor 100.

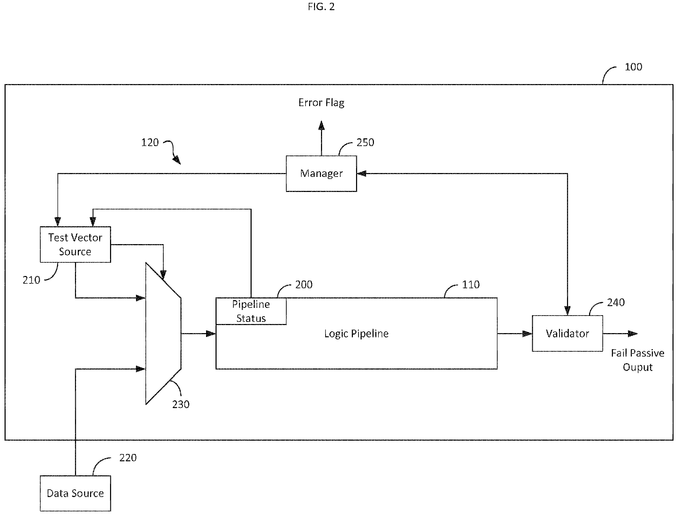

FIG. 2 is another block diagram of an exemplary processor 100 having a built-in configuration error detector 120, in accordance with an embodiment. The built-in configuration error detector 120 includes a pipeline status identifier 200. When the processor 100 is a SRAM based FPGA, for example, the pipeline status identifier 200 is constructed from the FPGA logic. The pipeline status identifier 200 indicates if the pipeline 110 is ready for new input. In other words, the pipeline status identifier 200 determines when there is available bandwidth in the logic pipeline 110 for testing the processor without interrupting the normal operation of the logic pipeline 110. When the logic pipeline 110 is ready for new data input and no new user data is ready to feed it, the pipeline status identifier 200 signals a test vector source 210, as discussed in further detail below. As the built-in configuration error detector 120 only tests during pipeline idle time, the processor 100 never experiences an interruption of normal operation when being tested by the built-in configuration error detector 120.

The test vector source 210 includes memory to store one or more test vectors, the anticipated result from a properly functioning pipeline, the maximum allowable time-to-execute for the input test stimulus, and control logic to initiate the built-in test. When the processor 100 is a SRAM based FPGA, for example, the memory and control logic is constructed from the FPGA logic. The test vectors stored in the test vector source 210 are predetermined bit strings, which when passed through the logic pipeline 110 should result in the anticipated results. As discussed in further detail below, the output of the logic pipeline 110 in response to the test vectors is used to verify the integrity of the logic pipeline 110. The test vector(s) may include a test vector flag. The test vector flag indicates that the data with the test vector flag is test data, rather than application data for normal operation of the logic pipeline 110. The logic pipeline 110, as discussed above, may have various uses. However, in some embodiments, such as motor control, an output of the logic pipeline 110 may be based upon data from a previous cycle. In these instances, the test vector flag indicates to the logic pipeline 110 to not overwrite any data saved in registers or other memory used in the logic pipeline 110, thereby preserving the correct data in the logic pipeline for a subsequent data pass through the logic pipeline 110.

In one embodiment, for example, the memory of the test vector source may be stored in an application SRAM (otherwise known as block random access memory (RAM) in FPGA applications). The application SRAM may be subject to error monitoring to ensure the stability of the test vectors in the test vector source 210. In one embodiment, for example, one or more of the test vectors stored in the memory may include an error correcting code (ECC). The ECC is used by the test vector source 210 to verify the integrity of the test vectors.

When the test vector source 210 receives an idle indication from logic pipeline 110 via the pipeline status identifier 200, the test vector source 210 initiates the built-in test by sending one or more test vectors to the logic pipeline 110. In the embodiment illustrated in FIG. 2, the logic pipeline 110 receives data for normal operation from a data source 220. The data source 220 is connected to the logic pipeline 110 through a multiplexor 230. The multiplexor 230 also receives data from the test vector source 210 for introducing the test vectors into the logic pipeline 110. The test vector source 210 controls which input, either the test vector source itself or the data source 220, is connected to the logic pipeline 110 by sending a control signal to the multiplexor 230. When test vector source 210 receives an indication of an idle condition in the logic pipeline 110 from the pipeline status identifier 200, the test vector source 210 initiates the built-in test by signaling the multiplexor 230 to connect the test vector source 210 to the logic pipeline 110 and by sending one or more test vectors to the logic pipeline 110 through the multiplexor. The test vector source 210 may also forward an expected value to the validator 240.

The processor 100 further includes a validator 240 coupled to the output of the logic pipeline. In one embodiment, for example, the validator 240 may include a memory, a comparator and a switch. When the processor 100 is a SRAM based FPGA, for example, the memory, comparator and switch may be constructed from the FPGA logic. The memory of the validator 240 stores the expected output of the logic pipeline to the test vector(s) input. The memory of the validator 240, like the memory of the test vector source 210, is subject to independent monitoring via an error correction code (ECC) in a similar manner as discussed above.

The validator 240, upon receipt of data having the test vector flag, compares the data output from the logic pipeline to the expected result stored in the memory of the validator 240. When the data output from the logic pipeline 110 does not match the expected data, the validator 240 may open its internal switch, cutting off the logic pipeline 110 from the output of the processor 100. Accordingly, rather than outputting possibly corrupted data, the validator 240 causes the processor 100 to output nothing at all. In other words, the validator 240 opening its internal switch upon detecting a difference via the comparator causes the processor 100 to have a fail passive output. In certain embodiments, such as motor control, having a fail passive output is vital. For example, if the logic pipeline 110 is configured to control a motor current, outputting a corrupted current command could damage the motor, the motor drive electronics, or the end user application as discussed above. Accordingly, by outputting no data in the event the logic pipeline becomes misconfigured, the processor 100 maintains a fail passive output.

When the data output from the logic pipeline 110 matches the expected data, the validator 240 may close its internal switch, if previously open, allowing the logic pipeline 110 to output data from the processor 100. In one embodiment, for example, the memory of the validator 240 may store one or more previously processed data sets by the logic pipeline 110 through the logic pipelines normal operation. In this embodiment, when the data output from the logic pipeline 110 after a test matches the expected data, the validator 240 may output one or more previously processed data sets from the memory of the validator 240. The validator 240 may then open the switch and save any subsequent data output from the logic pipeline 110 until the next configuration test result is received passes. Accordingly, in this embodiment all data output from the logic pipeline 110 can be assumed to be free of any possible FPGA configuration errors caused by radiation or other error sources as a subsequent pass of data from the test vector source 210 contained no errors. Furthermore, the configuration test completed previous to a current configuration test serves to verify that the configuration of the logic pipeline 110 was correct before the normal application data was processed. Accordingly, the built-in configuration error detector 120 is capable of verifying the configuration of the logic pipeline 110 before and after processing application data, thereby ensuring that valid data is output by the processor without the use of a voting system, nor reliant upon a slow-rate scrubbing of the processor 100.

When the validator 240 detects a configuration error, the validator 240 may send a signal to a processor manager 250. In one embodiment, for example, the processor manager 250 may output an error flag to one or more other systems or processors to indicate that an error has occurred in the logic pipeline 110. The result of the error flag may depend upon the system.

When the processor 100 is an ASIC or any other non-reprogrammable processor, the error flag may signal that the part needs to be replaced. In instances where the processor 100 is reprogrammable, such as when the processor 100 is a SRAM type FPGA, the error flag can be used to initiate a reprogramming of the processor 100 to correct the configuration error. In some embodiments, for example, the error flag could initiate a reboot of the processor 100. The error flag could initiate a power cycle of the processor 100.

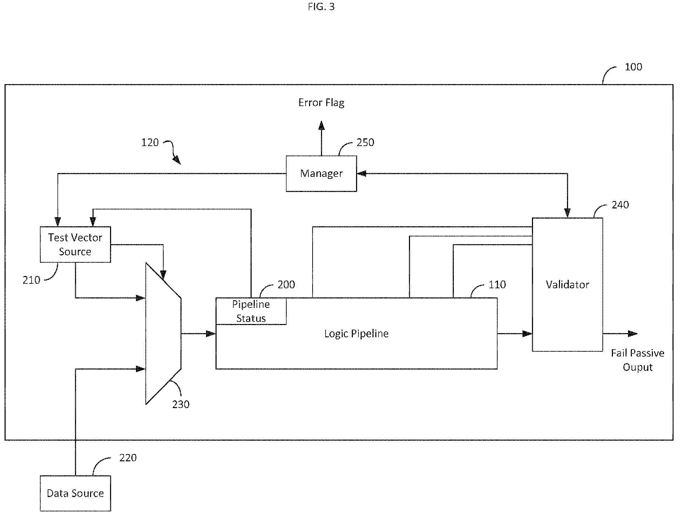

In the embodiment illustrated in FIG. 2, the validator 240 is only coupled to an output of the logic pipeline 110. However, the validator could be coupled to the logic pipeline 110 in multiple locations. FIG. 3 illustrates yet another block diagram of an exemplary processor 100 having a built-in configuration error detector 120, in accordance with an embodiment. In this embodiment the validator 240 is coupled to the logic pipeline at multiple locations. While FIG. 3 illustrates the validator 240 being coupled to the logic pipeline 110 in three locations in addition to the output of the logic pipeline 110, the validator 240 may be coupled to the logic pipeline 110 any number of times at any location along the logic pipeline 110. In this embodiment, the validator 240 may store an expected data value for each connection to the logic pipeline 110. In other words, the logic pipeline 110 should have a known value at each stage of the logic pipeline 110 in response to the known test vector. The validator 240, upon detecting the test vector flag accompanying the test vector data through the logic pipeline 110, compares the current data value of the logic pipeline 110 to the known data as the test vector propagates through the logic pipeline 110. As with the embodiment illustrated in FIG. 2, the validator 240 signals the processor manager 250 when the data received from the logic pipeline 110 does not match the expected data. However, in this embodiment, the validator 240 may also indicate a zone in the logic pipeline 110 where the error was detected. Accordingly, if the processor manager 250 or an external configurator is attempting the locate and fix the specific errors in the configuration of the logic pipeline 110 of the processor 100, the location of the error output by the validator can narrow down the zone needed to be tested. In other words, if the first two validator tests matched the expected data and the third validator test failed, the processor manager 250 or external processor configurator would only have to perform a configuration test on the zone of logic pipeline between the areas of the second and third connections between the logic pipeline 110 and the validator 240. This may significantly speed up the correction of the miss-configuration, thus returning the processor 100 to operation sooner.

When a response to the error detection includes an attempt to reconfigure the logic pipeline 110, via a scrubbing, a power cycle or any other method, the processor manager 250 may initiate a retest by signaling the test vector source 210 to retest the logic pipeline 110. The retest verifies that the configuration of the logic pipeline 110 is correct before the processor manager 250 allows the processor 100 to return to normal operation.

In one embodiment, for example, the error flag output by the processor manager 250 could be used to control an outside system. For example, if the processor 100 is being used to control a motor, the error flag may be used by the processor 100 or another external controller to stop the motors.

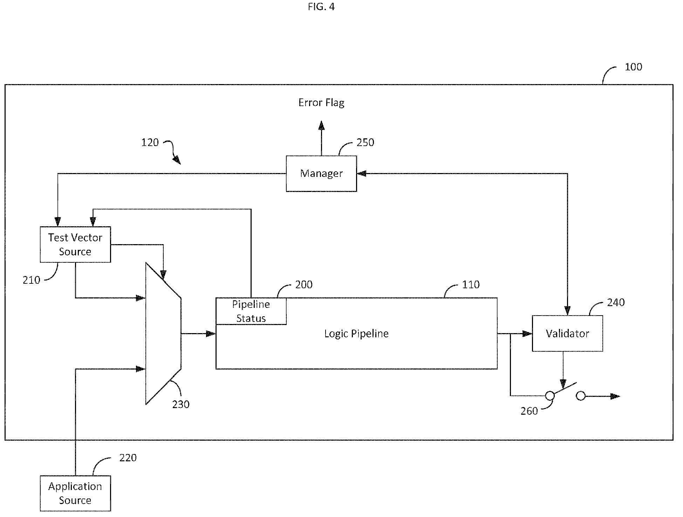

FIG. 4 illustrates yet another block diagram of an exemplary processor 100 having a built-in configuration error detector 120, in accordance with an embodiment. In this embodiment, the built-in configuration error detector 120 includes a switch 260 external to the validator 240, the switch 260 selectively directly coupling the output of the logic pipeline to the output of the processor 100. In this embodiment, the validator 240 includes a memory storing the expected data output from the logic pipeline in response to the test vector(s), but does not store previous output of the logic pipeline 110 in response to application data. In this embodiment, the switch 260 is controlled by the validator 240. The validator 240 keeps the switch 260 closed until the data output from the logic pipeline 110 in response to the test vector does not match the expected data stored in the memory of the validator 240. Bbecause the validator does not store results of the logic pipeline 110 in response to normal application data, the processor 100 could output corrupted data between tests. In other words, when the configuration of the logic pipeline 110 is changed due to exposure to ionizing radiation, the validator 240 cannot catch the error until the subsequent idle in the logic pipeline 110, possibly leading to corrupted output. Accordingly, while less secure that the embodiments illustrated in FIGS. 2 and 3, the configuration illustrated in FIG. 4 could be used in data intensive situations, such as video processing, where corrupted output (e.g., garbled video) could do little or no harm and deep buffer memories are not available.

The processor managers 250 response to the error detected by the validator 240 illustrated in FIG. 4 could include any of the response discussed above with respect to FIGS. 2 and 3.

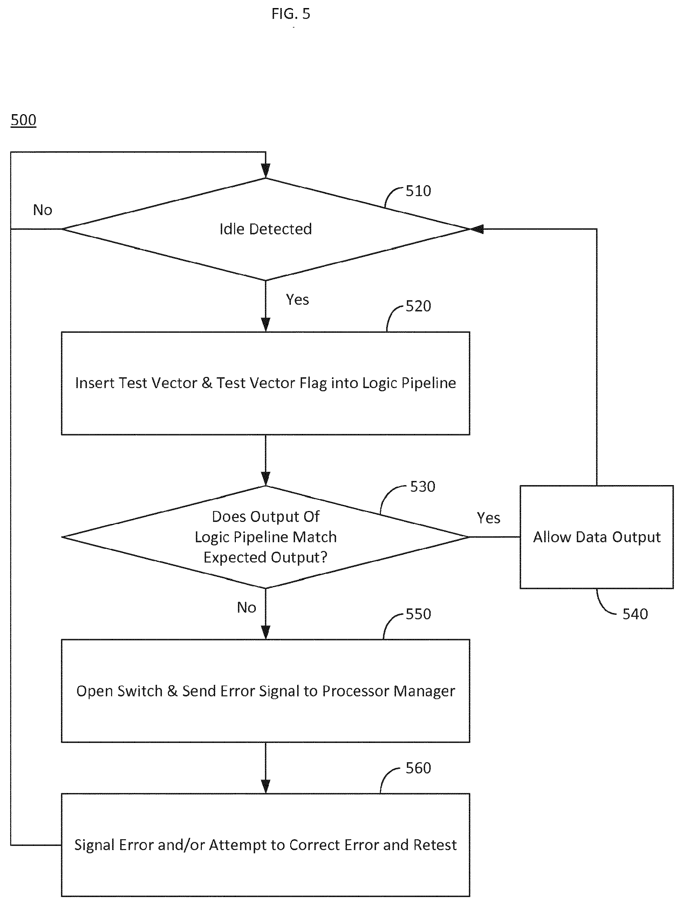

FIG. 5 is a flow diagram illustrating an exemplary method 500 for operating a processor having a built-in configuration error detector, in accordance with one embodiment. The method 500 begins when a pipeline status identifier 200 detects an idle state of the logic pipeline 110. (Step 510). As discussed above, by inserting test vectors into the logic pipeline when the logic pipeline has available bandwidth, the configuration of the logic pipeline 110 can be tested without interrupting normal operation of the processor 100. When the pipeline status identifier 200 indicates an idle condition in the logic pipeline 110, the pipeline status identifier 200 transmits a signal to the test vector source to insert a test vector into the logic pipeline 110. (Step 520). As noted above, the test vector may include a test vector flag. The test vector flag may cause the logic pipeline 110 to save any data in internal registers from normal application data. Accordingly, in instances where subsequent calculations are based on pervious calculations, the introduction of the test vectors into the logic pipeline 110 will not introduce errors into the calculations being performed by the logic pipeline. The test vector flag may also be utilized by the validator 240 to indicate when the validator 240 needs to test an output of the logic pipeline 110.

When the validator 240 identifies output of the logic pipeline accompanying a test vector flag, the validator compares the output to an expected output saved in memory. (Step 530). When the output of the logic pipeline matches the expected output, the validator closes a switch, if previously open, to allow the processor 100 to output data. (Step 540). In the embodiment illustrated in FIGS. 2 and 3, the validator may output data generated in response to normal application data saved in the memory of the validator 240. In this embodiment, after all of the existing data is output by the processor, the validator 240 may reopen the switch and save any subsequent logic pipeline output until a subsequent test is performed.

The validator 240, upon detecting a configuration error when the output of the logic pipeline does not match the expected output, opens a switch (either internal to the validator or an external switch 260), if previously closed, preventing the processor 100 to output data and sends a signal to a processor manager 250 indicating the configuration error. (Step 550). By opening a switch connecting the logic pipeline 110 to an output of the processor, the output of the processor is fail passive. In other words, rather than outputting corrupted data, the processor is prevented from outputting data entirely.

The processor manager 250, upon receiving an indication of a configuration error from the validator 240, may output an error signal and/or attempt to correct the configuration of the logic pipeline 110. (Step 560). The response to the detection of the configuration error may vary from system to system. In some embodiments, for example, the processor manager 250 may attempt to power cycle the processor 100 to initiate a reprogramming of the processor 100. In another embodiment, for example, the processor manager 250, or an external controller, could attempt to scrub the logic pipeline 110 to find and correction the configuration error. In these embodiments, the processor manager 250 may be configured to initiate a retest the logic pipeline 110 to ensure that the configuration of the logic pipeline 110 was corrected. When the configuration error was corrected, the processor manager 250 allows the processor to return to normal operation and the built-in configuration error detector returns to step 510 to await the next idle in the logic pipeline 110.

In instances where the logic pipeline 110 is not reprogrammable, the error signal may indicate that the processor 100 needs to be replaced or that a given computation might be repeated in an attempt to be fault tolerant to transient error. Depending upon the application of the processor 100, the processor manager 250 may allow the processor 100 to continue to process data or may prevent the processor 100 from returning to operation. For example, if the processor 100 is being utilized to generate video in a medical imaging device, the processor manager 250 may allow the processor to continue operation even though the data may be corrupted. When the processor 100 is in a satellite being used to generate motor data, the processor manager 250 may shut down operation of the processor 100.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A processor, comprising:
a logic pipeline configured to process input data, the logic pipeline comprising a pipeline status indicator configured to determine when the logic pipeline is idle;
a built-in configuration error detector coupled to the logic pipeline, the built-in configuration error detector configured to detect a change to a configuration of the logic pipeline, the built-in configuration error detector comprising:
a test vector source coupled to the pipeline status indicator and selectively coupled to an input of the logic pipeline, the test vector source storing at least one test vector, the test vector source configured to transmit the at least one test vector to the logic pipeline when the pipeline status indictor determines that the logic pipeline is idle; and
a validator coupled to an output of the logic pipeline, the validator configured to compare an output of the logic pipeline in response to the test vector to a predetermined data set, the validator configured to allow the processor to output data when the output of the logic pipeline in response to the test vector matches the predetermined data set and to block the processor from outputting data when the output of the logic pipeline in response to the test vector does not match the predetermined data set.

2. The processor of claim 1, wherein the validator further comprises a memory and the validator is further configured to store output of the logic pipeline in response to application data and further configured to output the stored data when the output of the logic pipeline in response to the test vector matches the predetermined data set.

3. The processor of claim 2, wherein the validator further comprises switch, the validator configured to close the switch when the output of the logic pipeline in response to the test vector matches the predetermined data set, and to open the switch when the output of the logic pipeline in response to the test vector does not match the predetermined data set.

4. The processor of claim 1, further comprising a switch coupled between the output of the logic pipeline and an output of the processor,
wherein the validator is coupled to the switch and configured to close the switch when the output of the logic pipeline in response to the test vector matches the predetermined data set, and to open the switch when the output of the logic pipeline in response to the test vector does not match the predetermined data set.

5. The processor of claim 1, further comprising a processor manager coupled to the validator, wherein the processor manager is configured to output an error flag when the output of the logic pipeline in response to the test vector does not match the predetermined data set.

6. The processor of claim 5, wherein the processor manager is further configured to scrub the logic pipeline for configuration errors.

7. The processor of claim 6, wherein the processor manager, after scrubbing the logic pipeline for configuration errors, transmits a signal to the test vector source to transmit the at least one test vector to the logic pipeline.

8. The processor of claim 1, wherein the validator is coupled to the logic pipeline at a plurality of different locations along the logic pipeline, and the validator is configured to output a zone of the logic pipeline where the logic pipeline is misconfigured.

9. The processor of claim 1, wherein the processor is a static random access memory field programmable gate array.

10. A built-in configuration error detector for a logic pipeline in a processor, comprising:
a test vector source coupled to a pipeline status indicator of the logic pipeline, the pipeline status indicator configured to determine when the logic pipeline is idle, the test vector source selectively coupled to an input of the logic pipeline, the test vector source storing at least one test vector, the test vector source being configured to transmit the at least one test vector to the logic pipeline when the pipeline status indictor determines that the logic pipeline is idle; and
a validator coupled to an output of the logic pipeline, the validator configured to compare an output of the logic pipeline in response to the test vector to a predetermined data set, the validator configured to allow the processor to output data when the output of the logic pipeline in response to the test vector matches the predetermined data set and to block the processor from outputting data when the output of the logic pipeline in response to the test vector does not match the predetermined data set.
